Europäisches Patentamt

European Patent Office

Office européen des brevets

(11) Publication number: **0 204 588**
**A2**

## EUROPEAN PATENT APPLICATION

(21) Application number: 86304358.4

(22) Date of filing: 06.06.86

(51) Int. Cl.⁴: **H 03 K 23/66**

(30) Priority: 06.06.85 GB 8514348

(43) Date of publication of application:
10.12.86 Bulletin 86/50

(84) Designated Contracting States:
DE FR IT NL

(71) Applicant: MOTOROLA, INC.
1303 East Algonquin Road
Schaumburg, Illinois 60196(US)

(72) Inventor: Daghighian, Hamid
Chemin Colladon 14
CH-1209 Genève(CH)

(74) Representative: Hudson, Peter David et al,
Motorola Patent and Licensing Operations - Europe Jays
Close Viables Industrial Estate
Basingstoke Hampshire RG22 4PD(GB)

(54) Digital Timer.

(57) A digital timer for use in a microprocessor comprising: an N-bit counter (2) having a clock input for receiving clock pulses and for counting in response thereto and for producing a first signal (UNFA) in response to the counter reaching a first predetermined count; an M-bit counter (8) having a clock input for receiving clock pulses and for counting in response thereto; bistable means (4) having a SET input coupled to receive the first signal of the N-bit counter, a RESET input and an output; an AND gate (6) having a first input coupled to the output of the bistable means, a second input coupled to the clock input of the N-bit counter and an output coupled to the clock input of the M-bit counter and to the RESET input of the bistable means; and means (16) coupled to receive the first signal of the N-bit counter and for producing a second signal in response to the M-bit counter having a second predetermined count when the first signal is produced, whereby the second signal is indicative of an (M+N)-bit count being reached.

FIG. 1

Digital Timer

This invention relates to a digital timers and particularly, though not exclusively, to such timers for use in microprocessors.

Although the term microprocessor is used herein it will be appreciated that the term is intended to cover not only microprocessors per se but also miniaturised processing devices generally, such as microcomputers, microcontrollers, etc.

A digital timer for use in a microprocessor is conventionally provided in the form of a counter which is clocked at a predetermined rate to count (usually down) from a predetermined starting value until a predetermined count is reached, at which time an overflow (or, more usually, underflow) signal is produced. Known timers of this kind typically use an 8-bit or 16-bit counter, depending on the counting range required. For some applications an 8-bit counter will be sufficient, whereas for other applications a 16-bit counter will be required.

To enable both of these requirements to be optimally satisfied in a single microprocessor has required counters of both kinds to be present in the microprocessor. This is clearly wasteful, especially where more than one timer must be provided.

It is an object of the present invention to provide a digital timer wherein the above disadvantage may be overcome, or at least alleviated.

In accordance with the present invention a digital timer for use in a microprocessor comprises:

an N-bit counter having a clock input for receiving clock pulses and for counting in response thereto and for producing a first signal in response to the counter reaching a first predetermined count;

- 2 -

0204588

an M-bit counter having a clock input for receiving clock pulses and for counting in response thereto;

bistable means having a set input coupled to receive the first signal of the N-bit counter, a reset input and an output;

an AND gate having a first input coupled to the output of the bistable means, a second input coupled to the clock input of the N-bit counter and an output coupled to the clock input of the M-bit timer and to the reset input of the bistable means; and

means coupled to receive the first signal of the N-bit counter and for producing a second signal in response to the M-bit counter having a second predetermined count when the first signal is produced,

whereby the second signal is indicative of an (M+N)-bit count being reached.

Preferably, the timer includes means coupled to receive the second signal and for producing a third signal in response to the N-bit counter having a non-zero count when the second signal is produced, the third signal being coupled to the reset input of the bistable means.

Preferably the N-bit counter and the M-bit counter are arranged to count decrementally and the first and second predetermined counts are both zero.

In a preferred embodiment the N-bit counter and the M-bit counter are both 8-bit counters.

Preferably the timer includes an OR gate having a first input coupled to receive the third signal, a second input coupled to the output of the AND gate and an output coupled to the reset input of the bistable means.

Preferably the timer includes first and second modulus latches associated respectively with the N-bit and M-bit counters and arranged to load their respective associated counters with predetermined N-bit and M-bit digital values respectively in response to the second signal.

Thus it will be appreciated that in a typical application of the invention, two 8-bit timers may be "concatenated" to produce a fully functional 16-bit timer.

A microprocessor including a digital timer in accordance with the invention will now be described, by way of example only, with reference to the accompanying drawings, in which:

Figure 1 shows a block schematic diagram of the digital timer within the microprocessor; and

Figures 2 and 3 show timing diagrams of various signals and counter levels occuring within the timer.

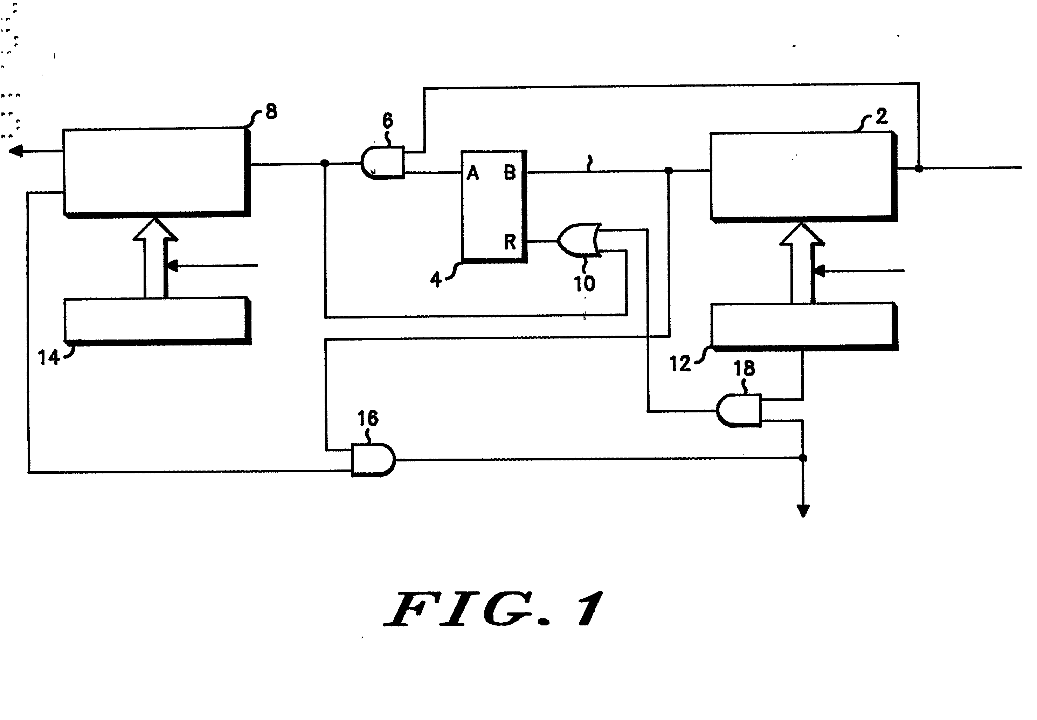

Referring now to Figure 1, a microprocessor includes a digital timer having a first 8-bit, clocked, decrementing counter 2 with its clock input coupled to receive clock pulses. The "underflow" output of the counter 2 (which is generated when the counter has a count of zero) is connected to the SET input of a flip-flop device 4. The non-inverting output of the flip-flop 4 is connected to one input of a two-input AND gate 6. The second input of AND gate 6 is connected to receive the same clock pulses as are applied to the clock input of the counter 2.

The output of AND gate 6 is connected to the clock input of a second 8-bit, clocked decrementing counter 8. The output of AND gate 6 is also connected to an input of an OR gate 10, whose output is connected to the RESET input of the flip-flop 4.

Modulus latches 12 and 14 are associated respectively with the counters 2 and 8 for loading the respective counters with predetermined 8-bit values held in the latches.

The underflow output of the counter 2 is also connected to one input of a two-input AND gate 16. The second input of the AND gate 16 is coupled to the counter 8 whereby a signal is applied to the second input of the AND gate 16 when the count of the counter 8 is zero.

- 4 -

0204588

The output of the AND gate 12 is applied to a first input of a two-input AND gate 18. The second input of the AND gate 18 is coupled to the modulus latch 12 whereby a signal is applied to the second input of the AND gate 18 when the value held in the modulus latch is non-zero. The output of the AND gate 18 is connected to an input of the OR gate 10.

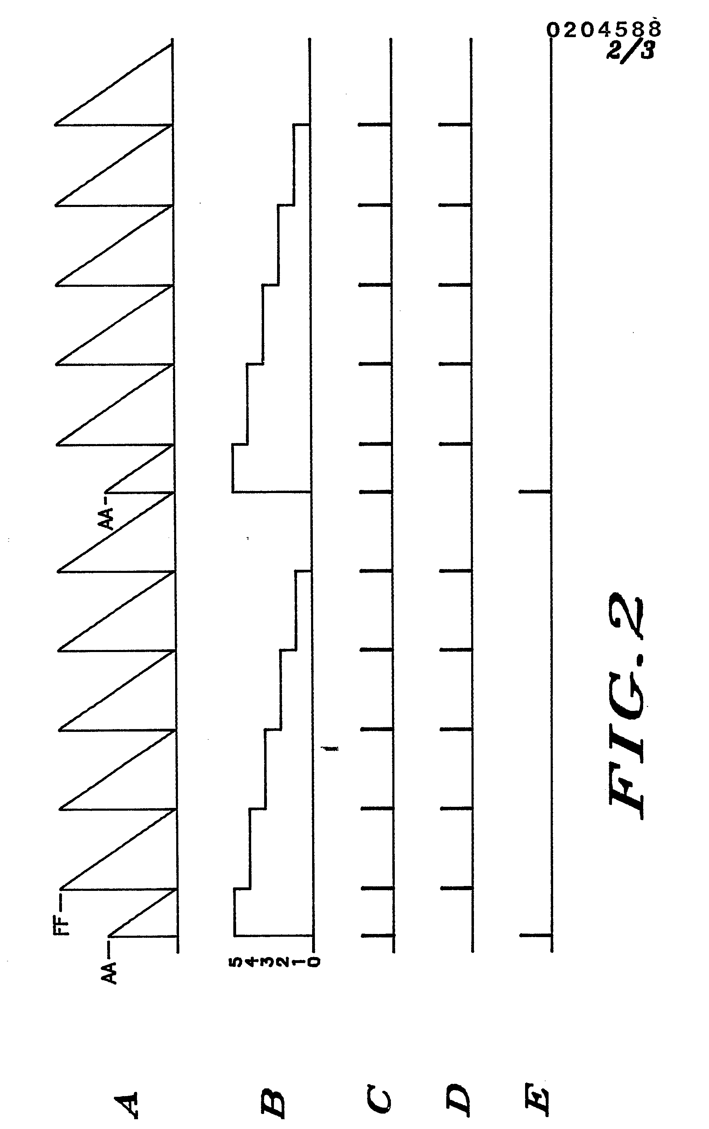

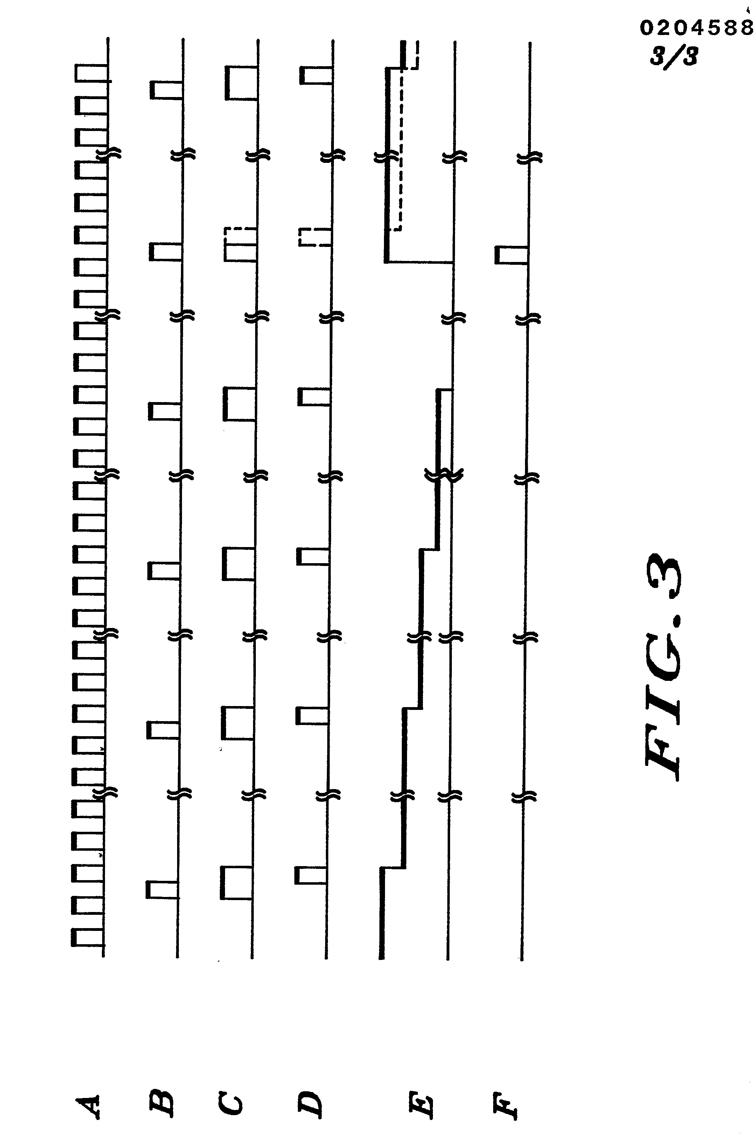

Referring now also to Figures 2 and 3, in use the timer operates as follows. The modulus latches 12, 14 simultaneously load the counters 2, 8 with their respective predetermined "starting" values, e.g. hexadecimal values AA (see Figure 2(a)) and 5 (see Figure 2(b)) respectively. At the beginning of the operation the flip-flop 4 is in its reset state.

With each clock pulse (see Figure 3(a)) received at its clock input the counter 2 is decremented until its count reaches zero. At this point the counter produces its underflow signal (UNFA - see Figures 2(c) and 3(b)) which sets the flip-flop 4. The setting of the flip-flop 4 produces a signal at the output Q of the flip-flop (see Figure 3(c)) which is applied to the AND gate 6. At the next clock pulse to the counter 2 the AND gate 6 produces a signal (see Figures 2(d) and 3(d)) at its output. This signal serves to reset the flip-flop 4 and also to "clock" the counter 8 so as to cause its count to be decremented. The count of counter 2 reverts to a hexadecimal value of FF and continues to be decremented with each clock pulse.

In this way the counter 2 is decremented and repeatedly produces its underflow signal which causes the counter 8 to be decremented. When the count of the counter 8 becomes zero (after five decrements in the present example) a signal is applied to the first input of the AND gate 16. The count of the counter 2 again reverts to hexadecimal FF and continues to be decremented, and when now it reaches zero its underflow signal applied to the AND gate 16 causes the AND gate to produce a signal (UNF16 - see Figures 2(e) and 3(f)) at its output.  It will be immediately appreciated that this signal is indicative of the two counters having collectively counted from a predetermined 16-bit value (hexadecimal 05AA in the present example) to zero.

Referring now more particularly to Figure 3, in the present example the UNF16 signal is used to cause the modulus latches 12, 14 to load their values into their respective counters 2, 8.  When a UNF16 signal is produced the flip-flop 4 is not reset.  Resetting of the flip-flop will normally occur at the next clock pulse to counter 2, by which time the counters 2, 8 will have been reloaded to their predetermined "starting" values.  Thus, it will be appreciated, an error might occur if following the production of a UNF16 signal the counters were simply reloaded and counting were allowing to proceed, since on the next clock pulse to the counter 2 following the UNF16 signal and reloading the AND gate 16 would produce its output, resetting the flip-flop but also decrementing the counter 8.  Clearly, such automatic decrementing of the count of the counter 8 would not be required unless the "starting" value for the counter 2 were zero.

In order to prevent such automatic decrementing of the counter 8 except when required, the UNF16 signal is also applied to the first input of the AND gate 18.  The second input of the AND gate 18 is coupled to the modulus latch 12 and a signal is applied to the second input of the AND gate 18 when the value held in the modulus latch 12 is non-zero.  Thus, when a UNF16 signal is produced the AND gate 18 produces its output signal if the modulus latch 12 holds a non-zero value.

The output signal produced by the AND gate 18 thus resets the flip-flop 4 in only those cases (i.e. non-zero "starting" values held in modulus latch 12 for counter 2) where "automatic decrementing" of counter 8 as described above must be prevented.  In the case (i.e. zero "starting" value held in modulus latch 12 for counter 2) where "automatic decrementing" of counter 8 must be allowed to take place no output signal is produced by the AND gate 18, leaving the flip-flop 4 in its set state following a UNF16 signal and allowing "automatic decrementing" of the counter 8 to occur at the next clock pulse applied to the counter 2.

The effect of this operation is shown particularly in Figures 3(c), 3(d) and 3(e) in which the full lines show pulse shapes as they occur when the AND gate 18 produces its output signal and the dotted lines show pulse shapes as they occur when no output signal is produced by the AND gate 18.

It will be appreciated that the above described timer functions as a fully-operational 16-bit timer while providing the flexibiltiy of parallel 8-bit operation (not shown) if desired by clocking each counter independently.

It will also be appreciated that although the above timer was described as using two 8-bit timers, any two counters of any desired number of bits may be used to provide a fully-functional timer having as its effective number of bits the total number of bits of the individual counters, or that if desired more than two counters could be combined in this way.

CLAIMS

1.  A digital timer for use in a microprocessor comprising:

an N-bit counter having a clock input for receiving clock pulses and for counting in response thereto and for producing a first signal in response to the counter reaching a first predetermined count;

an M-bit counter having a clock input for receiving clock pulses and for counting in response thereto;

bistable means having a set input coupled to receive the first signal of the N-bit counter, a reset input and an output;

an AND gate having a first input coupled to the output of the bistable means, a second input coupled to the clock input of the N-bit counter and an output coupled to the clock input of the M-bit timer and to the reset input of the bistable means; and

means coupled to receive the first signal of the N-bit counter and for producing a second signal in response to the M-bit counter having a second predetermined count when the first signal is produced,

whereby the second signal is indicative of an (M+N)-bit count being reached.

2.  A digital timer according to claim 1 including means coupled to receive the second signal and for producing a third signal in response to the N-bit counter having a non-zero count when the second signal is produced, the third signal being coupled to the reset input of the bistable means.

3. A digital timer according to claim 1 or 2 wherein the N-bit counter and the M-bit counter are arranged to count decrementally and the first and second predetermined counts are both zero.

4. A digital timer according to claim 1, 2 or 3 wherein the N-bit counter and the M-bit counter are both 8-bit counters.

5. A digital timer according to claim 1, 2, 3 or 4 including an OR gate having a first input coupled to receive the fourth signal, a second input coupled to the output of the AND gate and an output coupled to the reset input of the bistable means.

6. A digital timer according to any preceding claim including first and second modulus latches associated respectively with the N-bit and M-bit counters and arranged to load their respective associated counters with predetermined N-bit and M-bit digital values respectively in response to the second signal.

7. A microprocessor including a digital timer according to any preceding claim.

FIG. 1

1/3

0204588

A

B

C

D

E

FIG. 2

020458
2/3

## FIG.3